Europäisches Patentamt

European Patent Office

Office européen des brevets

(11) Veröffentlichungsnummer: 0 393 312
A1

## (12) EUROPÄISCHE PATENTANMELDUNG

(21) Anmeldenummer: 90101993.5

(22) Anmeldetag: 01.02.90

(51) Int. Cl.5: **H05K 1/03, H05K 1/00, H05K 1/16**

(30) Priorität: 21.04.89 CH 1531/89

(43) Veröffentlichungstag der Anmeldung:
24.10.90 Patentblatt 90/43

(84) Benannte Vertragsstaaten:
AT BE CH DE FR GB IT LI NL SE

(71) Anmelder: CONTRAVES AG
Schaffhauserstrasse 580
CH-8052 Zürich(CH)

(72) Erfinder: **Martinelli, Marco**
**Rankstrasse 12**
**CH-8413 Neftenbach(CH)**
Erfinder: **Schmidt, Walter, Dr.**
**Oberwiesenstrasse 73F**
**CH-8050 Zürich(CH)**
Erfinder: **Reuter, Hans-Jürgen**
**Tödistrasse 26**
**CH-8304 Wallisellen(CH)**

(54) **Mehrlagige Leiterplatte.**

(57) In einer mehrschichtigen Leiterplatte mit mindestens zwei durch eine elektrisch isolierende Zwischenschicht (2) voneinander beabstandete Leiterebenen (11), sind in die Leiterplatte mechanisch verstärkende Mittel (10) einlaminiert, welche die Leiterplatte versteifen und in vorbestimmten Abschnitten zugleich elektrische Leiterbahnen bilden, die dem elektrischen Layout der Leiterplatte zugeordnet sind. Auf diese Weise sind die elektrischen, wie auch die mechanischen Eigenschaften des Einlagematerials gleichzeitig genützt. Dieses Material (10) ist vorzugsweise elektrisch leitender Kohlenstoff in Form von Kohlenstofffasern. Ein Prepreg aus Kohlestofffasern kann in Form eines Layouts in den Multilayer einlaminiert sein und teilweise oder ganz die elektrischen Funktionen übernehmen und gleichzeitig als Verstärkung wirken.

FIG. 4

EP 0 393 312 A1

Die Erfindung betrifft ein Verfahren zur Herstellung von mehrlagigen Leiterplatten und mit diesem Verfahren hergestellte mehrlagige Leiterplatten gemäss Oberbegriff des Haupt-Patentanspruchs für das mit dem Verfahren hergestellte Produkt.

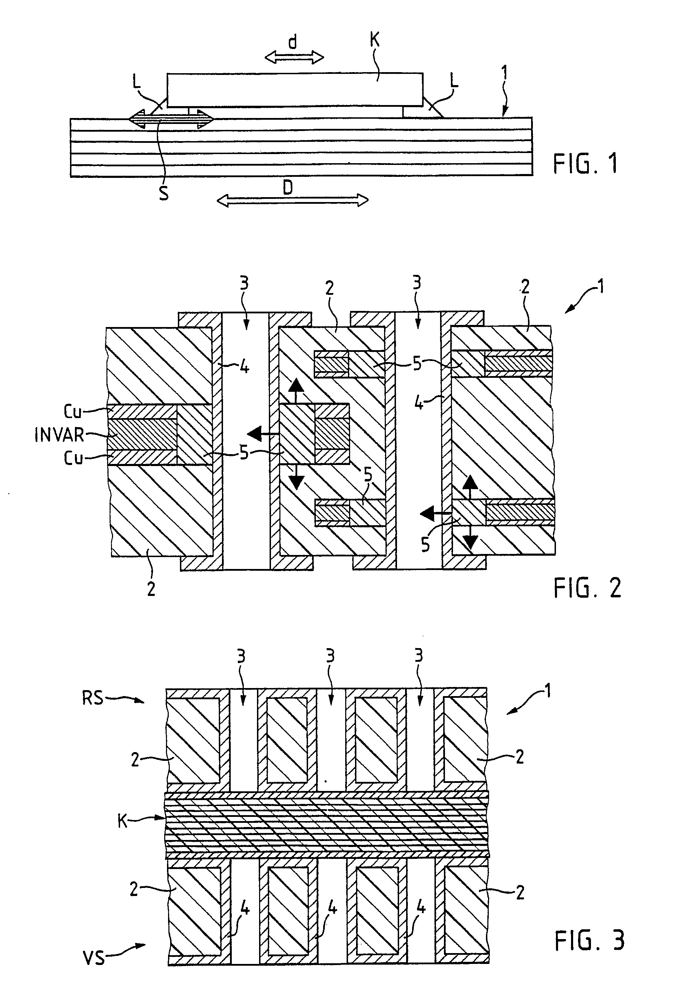

In der herkömmlichen Technologie der Leiterplatten werden bedrahtete Bauelemente eingesetzt, deren Drahtbeine als federndes Element, allfällige Unterschiede in der Wärmeausdehnung zwischen Platte und Bauteil ausgleichen können, wodurch die gefürchtete Rissbildung in den Lötstellen verhindert wird. Im Zuge der Verwendung von oberflächenmontierbaren Bauteilen (SMD's auch SMT-Technik) und der direkten Lötung oder stromleitenden Klebung dieser Bauelemente auf die Leiterplatte, also ohne Einbezug eines federnden Zwischenelements zwischen Bauteil und Leiterplatte, gewinnt die Problematik der Wärmeausdehnung von Platte und Komponenten sehr an Bedeutung (**Figur 1**). Insbesondere sind die keramischen Bauteile K, die heute bei hochwertiger Elektronik auf Leiterplatten immer mehr Verwendung finden, gefährdet, da der Ausdehnungskoeffizient von Keramik mit 6-7 ppm/$^\circ$C, dargestellt mit einem kleinen Doppelpfeil d, sich vom Ausdehnungskoeffizient der Leiterplatte 1 mit 16-20 ppm/$^\circ$C, dargestellt mit einem grossen Doppelpfeil D, stark unterscheiden, wodurch bei einer Temperaturänderung der Leiterplatte starke Scherspannungen an den Lötstellen auftreten, dargestellt durch einen gestreiften Doppelpfeil S unterhalb der Lötstelle L. Bei wiederholter Temperaturänderung kann dies schliesslich zu Rissen in den Lötstellen oder sogar zu Rissbildungen in den Keramikteilen selbst führen.

Daher werden bereits seit Jahren Anstrengungen unternommen, diese Problematik durch Verwendung von anderen Basismaterialien für die Leiterplatten, bzw. durch den Einsatz von stabilisierenden Einlagen wie Folien etc. zu lösen.

Die heute bekannten Methoden kann man generell in zwei Gruppen einteilen:

Substitution: (Beispiele)

- Ersatz der Silikat-Glasfasern im Epoxid- oder Polyimidharz durch:
- Quarzglasfasern (Quarzglas hat eine verschwindend kleine Wärmeausdehnung)
- Kevlar-Fasern (Kevlar hat einen negativen Temperaturkoeffizienten)

Komposition: (Beispiele)

- Einlaminieren von stabilisierenden Metall-Folien mit einem kleinen Ausdehnungskoeffizienten:
- Kupfer-Invar-Kupfer Schichtwerkstoffe, bei dem das Invar mit einem Temperaturkoeffizienten von 2 ppm/$^\circ$C die Stabilisierung bewirkt.

- Molybdänfolien mit einem Temperaturkoeffizienten von 5,3 ppm/$^\circ$C, die sich verhältnismässig wenig ausdehnen und
- Molybdän-Kupfer-Folien mit einem einstellbaren Kupferanteil.

Alle diese Lösungen, in beiden Gruppen, weisen zum Teil gravierende Nachteile auf.

Bei den Substitutionsverfahren sind beispielsweise Quarzfasern sehr schwer mechanisch zu bearbeiten, das heisst, beim Durchbohren, wie es zur Herstellung von Leiterplatten üblich ist, nützt sich der Bohrer sehr schnell ab, oder bricht sogar. Daher hat sich diese Art von mechanischer Verstärkung von Leiterplatten in grossem Masse auch nicht durchsetzen können. Ausserdem sind Quarzfasern vergleichsweise teuer. Dann die Kevlarfasern, die aus Kunststoff (Aramid) bestehen, sind extrem zäh und mechanisch kaum bearbeitbar. Sie werden beim Durchbohren nicht etwa abgeschnitten, sondern abgequetscht. Dies führt zu fasrigen Bohrlochwandungen und damit zu Qualitätsproblemen. Auch der Endzuschnitt der Leiterplatten ist aus diesen Gründen sehr schwierig zu bewerkstelligen. Dadurch, dass sich die Kevlarfasern durch den zu grossen negativen Temperaturkoeffizienten bei zunehmender Temperatur zusammenziehen und nicht ausdehnen, wie dies bei der sie umgebenden Harzmatrix der Fall ist, bilden sich extreme Scherspannungen zwischen Harz und Faser, was zu Mikrorissen in der Harzmatrix führt. Zudem können sich durch derart grosse Scherspannungen die Fasern aus der Matrix lösen (Separierung), was zu Zuverlässigkeitsproblemen führt. Ausserdem ist dieser Werkstoff ebenfalls verhältnismässig teuer.

Bei den Kompositionsverfahren werden Folienbleche bspw. aus Kupfer-Invar-Kupfer (CIC), die ihrerseits durch Aufweinanderwalzen von zwei Kupferfolien auf einen Invar(Ni-Fe)-Träger hergestellt werden, in der Art eines Sandwiches in den Mehrlagenaufbau mit einbezogen (**Figur 2**). CIC-Folienbleche weisen je nach Invar-Anteil einen Temperaturkoeffizienten zwischen 4-10 ppm/$^\circ$C auf. Will man einen Multilayer mit Hilfe einer solchen Folie bspw. auf eine Temperaturkoef fizienten von 6,5 ppm/$^\circ$C stabilisieren, was etwa dem des Keramikmaterials entspricht, so müssen 40-60% der Leiterplattendicke aus solchen Folienblechen bestehen, da sonst das Harzmaterial mit seinem Temperaturkoeffizienten von 16 ppm/$^\circ$C überwiegt.

Die Möglichkeit, ein Komposit auf einen bestimmten Ausdehnungskoeffizienten zu stabilisieren, kommt daher, dass solche Folienbleche einen relativ niedrigen Elastizitätsmodul aufweisen (110-140 kN/cm$^2$) aufweisen. Damit dehnen sich die im Harzmaterial 2 eingeschlossenen Folienbleche CIC mit dem Harzmaterial mit. Der relativ hohe Anteil an Folienblech in der Leiterplatte führt aber zu folgenden Nachteilen: Bei einer Leiterplattendicke von 1,6 mm muss bspw. ein Folienblech von 0,8 mm Dicke integriert werden. Dies kann man bewerkstelligen, in dem man eine 0,8 mm dicke Kernfolie, oder aber zwei 0,4 mm dicke Kernfolien voneinander beabstandet in den Aufbau einlaminiert. Bei Verwendung von zwei Folien, müssen diese aber symmetrisch zu einer neutralen Ebene angeordnet sein, um bei Temperaturänderungen eine Verbiegung der Leiterplatte zu verhindern.

Bei durchgehenden Verbindungs-Löchern 3, wie dies in Figur 2 dargestellt ist, ergibt sich aber das Problem, dass beim Freiätzen (das heisst, an den Stellen, an denen die durchplattierte Kupferhülse 4 der Bohrungen 3 nicht an das Folienblech elektrisch angeschlossen ist) der dadurch gebildete Hohlraum 5 wieder blasenfrei mit Harz ausgefüllt werden muss (Figur 2). Dies ist bei Einlagefolien mit einer Dicke von mehr als 150 $\mu$ bereits schon schwierig und nur unter Anwendung von Vakuum während des Verpressens der einzelnen Lagen zu einem Multilayer überhaupt erreichbar.

Ferner ist von gravierendem Nachteil, dass ein solcher Hohlraum, durch das Verpressen mit reinem, nicht mit Fasern verstärktem Harz aufgefüllt wird. Dieses faserfreie Harz hat aber einen noch höheren Wärmeausdehnungskoeffizient (30-100 ppm/$^\circ$C), was dazu führt, dass bei einem Temperaturwechsel der ring- oder zylinderförmige Harzanteil sein Volumen stärker ändert als seine armierte Umgebung. Der Umgebungsbereich der Kupferhülse dehnt sich somit stark aus und die Hülse wird dementsprechend mechanisch belastet. Dieser Sachverhalt ist in Figur 2 dargestellt und zwar durch drei Pfeile, die je in eine andere Richtung zeigen. Selbstverständlich gilt dies für alle Harzfüllungen, auch wenn in Figur 2 nur an zwei Stellen die Spannungsunterschiede aufgezeigt sind. Es kommt noch hinzu, dass die Bohrlochwandung in diesem Bereich durch das Fehlen der Glasfaserverstärkung sehr glatt ist und einer galvanisch eingebrachten Kupferhülse 4 keine Verankerungsmöglichkeiten bietet. Dadurch kommt es früher oder später zu Ablösungen der Kupferhülse von der Lochwandung, was eine zusätzliche Bruchgefahr mit sich bringt.

Ein weiterer wesentlicher Nachteil ist die geringe Wärmeleitfähigkeit von Invar-Legierungen.

Des weitern ist zu bedenken, dass Invar spanabhebend schwierig zu bearbeiten ist, da die FeNi-Legierung schmiert und damit insbesondere das Bohren von kleinen Löchern durch die einlaminierte Folie sehr erschwert wird. Bei Anwendungen, bei denen das Gewicht der Leiter-Platten eine Rolle spielt, z.B. in der Avionik-Elektronik, wirkt sich das erhöhte Leiterplattengewicht negativ aus. Das relativ hohe Eigengewicht solcher Leiterplatten führt in der Folge auch zu hohen Vibrations-Resonanzfrequenzen, die bekanntermassen unerwünscht sind.

Auch die wesentlich besser scheinende Alternative mit Rein-Molybdänfolien konnte sich nicht durchsetzen. Dieses Material hat zwar einen gut angepassten Temperaturkoeffizienten und auch die Wärmeleitfähigkeit ist gegenüber Invar wesentlich besser. Sehr problematisch ist dagegen die mechanische Bearbeitung, zudem ist das Material auch sehr teuer. Die hohen Scherspannungen, die sich an der Grenzfläche zwischen Folie und Basismaterial aufbauen, bedingen ausserdem eine spezielle Vorbehandlung, die bei Molybdän extrem aufwendig ist.

Man hat neuerdings in Anlehnung an CIC auch Folien aus Molybdän und Kupfer verwendet, die gegenüber Kupfer-Invar-Folien eine verbesserte mechanische Bearbeitbarkeit, eine recht hohe Wärmeleitfähigkeit und gegenüber CIC einen fast doppelt so hohen E-Modul aufweisen. Auch hier kann Figur 2 zur Illustration herangezogen werden. Die hohe Steifigkeit des Materials führt indessen dazu, dass Multilayer mit gezwungenermassen symmetrisch zur Mittelebene einlaminierten Folien ein hohes Trägheitsmoment aufweisen. Dies führt zu hohen Vibrations-Resonanzfrequenzen, wie dies bei allen stabilisierenden Metalleinlagen der Fall ist. Die übrigen Probleme, die im Zusammenhang mit den Kupfer-Invar-Kupfer-Folien (CIC) erörtert wurden, bleiben auch bei der Verwendung von Molybdän-Laminaten ungelöst.

Als ganz neu wurden vor weniger als einem Jahr mit Kohlefaser verstärkte Komposite bekannt. Kohlefasern werden immer dann eingesetzt, wenn hochfeste, steife, stabile und leichte Teile hergestellt werden müssen. Kohlefasern weisen einen sehr hohen E-Modul auf (bis drei mal höher als Stahl). Sie sind leicht als Gewebe oder als Prepreg (das ist ein mit Harz getränktes Gewebe) erhältlich und der Wärmeausdehnungskoeffizient ist nahe Null bzw. sogar leicht negativ. Damit würde sich dieser Werkstoff zur Herstellung von Multilayern eignen, was auch schon versucht worden ist (Publikation 1988 in Circuit World, Vol. 14, Nr.2, siehe auch Figur 3).

Allerdings muss man sehen, dass diese positiven Eigenschaften nur in der Faserlängsrichtung gelten, ausserdem ist zu beachten, dass diese Fasern elektrisch leitend sind, was einen generellen Einsatz verbietet. Es sind daher spezielle Multilayer-Aufbauten zu definieren, die das Problem der elektrisch leitfähigen Fasern umgehen.

Figur 3 zeigt einen Vorschlag von R. L. Williams et al., der 1988 in Circuit World publiziert wurde, in welchem ein Multilayer-Aufbau 1 einen kohlefaserverstärkten Kern K aufweist und sich speziell für hochdicht bestückte Leiterplatten eignen soll. In dieser Publikation werden die weiter oben genannten Nachteile der anderen Technologien bestätigt. Allerdings untersuchte man gemäss diesem Paper lediglich das "Schichtverhalten" von verschiedenen Sandwiches, aus Glasfaser/Epoxy-Schichten, Kupferschichten und Graphitfasernschichten bestehend, bezüglich Temperaturunterschieden. Die Messungen beschränkten sich auf das Aufzeigen der linearen Ausdehnung solcher Sandwiches in Funktion der Temperatur. Doch ist solch ein Sandwich noch kein Multilayer im Sinne einer Leiterplatte.

Die vorgeschlagenen Sandwiches haben den üblichen sehr grossen Nachteil, dass ein zentraler Kern stets einen symmetrischen Aufbau bedingt, das heisst, es muss auf der einen Seite RS (bspw. Rückseite) des Kerns ein zur anderen Seite VS (bspw. Vorderseite) gleichartig aufgebauter Multilayer auflaminiert werden. Wenn diese Forderung nicht peinlichst beachtet wird, wird sich der gesamte Aufbau bei einer Temperaturänderung, bedingt durch den gleichen Effekt, die bei einer Bimetallfeder, stets mehr oder weniger stark durchbiegen. Damit ist auch hier der Nachteil aller bisherig bekannten Komposite nicht ausgetilgt, wobei noch die Leitfähigkeit der Kohlefasern berücksichtigt werden muss, sobald irgendwelche Durchführungen bzw. Bohrungen durch solch einen Sandwich hergestellt werden müssen. Dies wäre der Fall, wenn die in Figur 2 eingezeichneten Sacklöcher 3 durch die Kernschicht geführt würden. Damit zeigt diese Publikation lediglich, dass mehrschichtige Platten aus Leiterplattenmaterial im Verbund mit Graphitfasern eine geringe Wärme-Ausdehnung aufweisen, jedoch nicht, wie eine mehrschichtige Leiterplatte hergestellt wird.

Gemäss den oben beschriebenen Umständen sollen für die thermischmechanische Ausdehnungs-Stabilisierung von Multilayern folgende Voraussetzungen erfüllt werden.

- Die Wärmeausdehnung des stabilisierenden Materials sollte möglichst klein sein.
- Der Elastizitätsmodul des Materials sollte möglichst hoch sein.
- Das Material sollte einfach in den Multilayer zu verarbeiten sein und nachträglich auch einfach zu bearbeiten sein.
- Das Material sollte eine möglichst geringe Dichte haben.
- Es sollte billig und gut erhältlich sein.
- Und dann sollte das Material noch eine möglichst hohe Wärmeleitfähigkeit aufweisen.

Diese Forderungen können kaum alle von einem einzigen Material erfüllt werden. Daher muss davon ausgangen werden, dass die Kombination verschiedener Materialien zur optimalen Lösung führen wird.

Es ist daher die Aufgabe der Erfindung ein Komposit von Materialien anzugeben, das alle diese Forderungen erfüllt und mit welchem Multilayer hergestellt werden können, die die Nachteile bekannter Multilayer nicht mehr aufweisen. Ausserdem ist es Aufgabe der Erfindung, ein Herstellungsverfahren für Multilayer aufzuzeigen, mit welchem alle Vorteile eines solchen Komposits optimal genützt werden können.

Diese Aufgabe wird gelöst durch die in den unabhängigen Patentansprüchen definierte Erfindung.

In den unten aufgeführten Figuren, von denen die ersten drei schon besprochen wurden, sind verschiedene Beispiele von Aufbaulösungen zu einer Mehrschicht-Leiterplatte (Multilayer) gezeigt, an denen die Erfindung nun diskutiert wird.

Fig. 1 zeigt die Problemstellung bei oberflächenmontierten Bauteilen (SMD oder SMT Technik).

Fig. 2 zeigt einen bekannten Aufbau, in dem zur mechanischen Stabilisierung Metallfolien verwendet werden.

Fig. 3 zeigt einen bekannten Aufbau, in dem zur mechanischen Stabilisierung Kohlefasern verwendet werden.

Fig. 4 zeigt eine erste Ausführungsform in einem Aufbau gemäss Erfindung, bei welchem gezeigt wird wie die Verstärkungsfasern (Kohlefasern) nicht in die Stromleitung miteinbezogen sind. Dies kann in Teilabschnitten der Einlage und/oder in einer oder mehreren Lagen eines Multilayers der Fall sein und

Fig. 5 zeigt eine zweite Ausführungsform in einem Aufbau gemäss Erfindung, bei welchem gezeigt wird, wie die Verstärkungsfasern (Kohlefasern) in die Stromleitung miteinbezogen werden. Dies kann auch in Teilabschnitten der Einlage und/oder in einer oder mehreren Lagen eines Multilayers der Fall sein, und

Fig. 6 zeigt eine dritte Ausführungsform in einem Aufbau gemäss Erfindung, bei welchem gezeigt wird, wie die Verstärkungsfasern (Kohlfasern) topologisch anders angelegt sind und neben der mechanischen Stabilisierung nicht nur als Leiterebenen sondern auch als Leiterbahnen dienen können.

Fig. 7 zeigt einen beispielsweisen Layout einer Verstärkungslage innerhalb eines Multilayers.

Die Erfindung geht von der Idee aus, die eingesetzten Materialien nicht nur bezüglich Auswahl und Kombination zueinander geschickt zu nützen, um deren Vorteile auf die Herstellung von Multilayern zu übertragen, sondern auch topologisch so einzusetzen, dass die mechanische Stabilisierung in den elektrischen Layout (elektrische Funktion) des Multilayers integriert wird. Ein solches Komposit ist nicht mehr eine ledigliche Zusammengesetztheit von Werkstoffen, mit welcher die jeweiligen Eigenschaften der einzelnen Werkstoffe gegeneinander ausgespielt werden, sondern ein Ineinanderweben dieser Eigenschaften derart, dass keine strikte Getrenntheit zwischen mechanischen und elektrischen Funktionen mehr besteht, aber beide wirksam bleiben. Als Materialien sind hier vorzugsweise Kohlestoff in Form von Kohlefasern und ein verbindendes Harzmaterial miteinander komponiert. Die Verbindung der Eigenschaften besteht bspw. darin, dass die mechanisch stabilisierenden Mittel in den Layout miteinbezogen werden, dass die mechanisch stabilisierenden Mittel zur Stromleitung herangezogen werden kann (ganz oder teilweise), dass die mechanisch stabilisierenden Mittel in Teilen die Funktion von elektrischen Bauelementen übernehmen, dass die mechanisch stabilisierenden Mittel asymmetrisch im Multilayer angeordnet sein können, um auch Aufgaben der elektrischen Seite zu übernehmen, was je nach dem bei einer "Schicht" nicht möglich ist, et cetera.

An Stelle von Kohlfasern können auch andere Materialien mit ähnlich gesuchten Eigenschaften verarbeitet werden, die unter Umständen heute noch gar nicht bekannt sind. Die Erfindung ist also nicht an das Material Kohlfaser gebunden, vielmehr an ein Material, das die gesuchten Eigenschaften auf sich vereint, und an die Art und Weise, mit diesem Material gemäss Erfindung umzugehen.

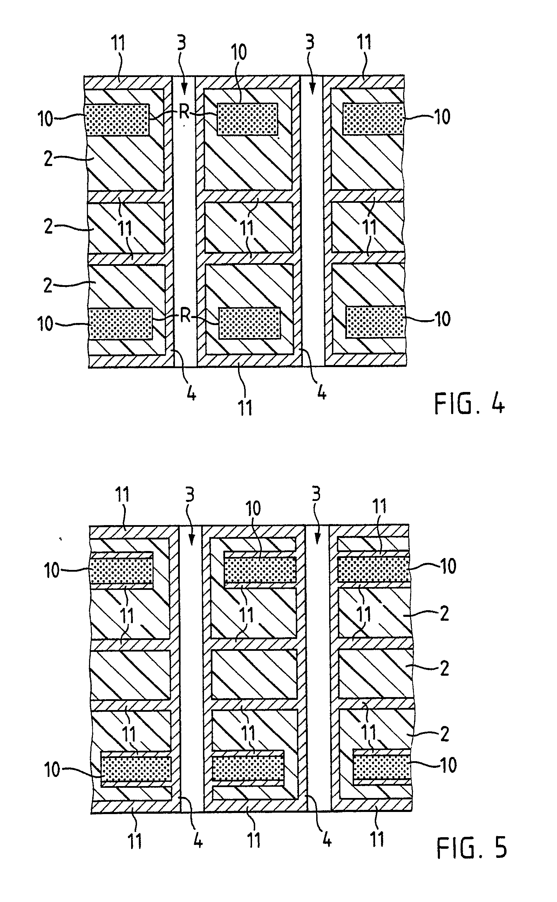

**Figur 4** zeigt nun einen ersten erfindungsgemässen Aufbau eines Multilayers. Die CFK-Prepregs 10 werden vorgepresst und anschliessend durch Bohren oder Fräsen weiterbearbeitet. Die Weiterbearbeitung besteht im Einbringen eines Bohrbildes oder, besser gesagt, eines auf den Multilayer bezogenen Layouts, welches direkt in die Kohlefasern enthaltende Zwischenschicht eingebracht wird. Dieser Layout kann ein bspw. Universalmuster für GND oder Vcc sein oder ein ganz spezifisches Bohrbild, jedenfalls ist er ein Teil des gesamten Layouts, so wie es bspw. eine Maske bei der Herstellung eines Halbleiter-Chips ist. Diese Weiterbearbeitung der Zwischenschicht kann bspw. leicht mittels computerunterstütztem Wasserstrahlschneiden erfolgen, eine Technik, die schnell ist und eine saubere Bearbeitung gewährleistet. Die vorfabrizierten Lagen 10 werden dann in den Multilayer 1 so einlaminiert, dass die Kohlefasern keine elektrischen Kurzschlüsse bewirken können, aber dort elektrisch leiten, wo es erwünscht ist. Es können ganze Leiterbahnen aus Kohlefasern bestehen, die wie ein Scherenschnitt in den Multilayer eingebettet sind und elektrische Leitung wie mechanische Festigung zugleich bewirken.

Soll bspw. die Kohlefaserschicht gegen eine elektrische Durchführung isoliert sein, dann werden die "Ränder" R der Ausschnitte im Prepreg etwas zurückversetzt gegenüber den eigentlichen Ausschnitten des bspw. Bohrbildes im Multilayer, wie dies in Figur 4 gezeigt ist. Mit anderen Worten, die Ausschnitte des Layout sind stets ein wenig grösser, als dies im Harzmaterial des Multilayers der Fall ist.

Man kann jedoch die elektrische Leitfähigkeit der Kohlefasern gezielt ausnützen **(Figur 5)**. In diesem Beispiel ist die Kohlefasereinlage selber mit einem elektrisch leitenden Material, vorzugsweise mit Kupfer, laminiert. Ein solches Komposit kann als stromleitende Lage, bspw. als GND oder Vcc in einem Multilayer, nebst Lagen, wie sie im Zusammenhang mit Figur 4 diskutiert wurden, verwendet werden. Bei einer solchen Anwendung wirkt sich die elektrische Leitfähigkeit der Kohlfasern natürlich positiv aus. In Figur 5 sind alle stromführenden Lagen mit 11 bezeichnet, ungeachtet, ob dies mit den verstärkenden CFK-Lagen zusammenfällt oder nicht. Hier sind die mechanisch versteifenden, elektrisch leitenden Lagen gleichrangig, wie die elektrisch leitenden Lagen des Layouts, der aber keine mechanisch stabilisierende Wirkung hat. In bestimmten Regionen kann die Kupferschicht weggeätzt sein, um an der Uebergangsstelle Cu-C-Cu einen elektrischen Widerstand zu bilden, durch welchen von der mechanisch stabilisierenden eine elektrische Komponentenfunktion erfüllt wird, was in die Layout-Vorbehandlung miteingeplant werden kann.

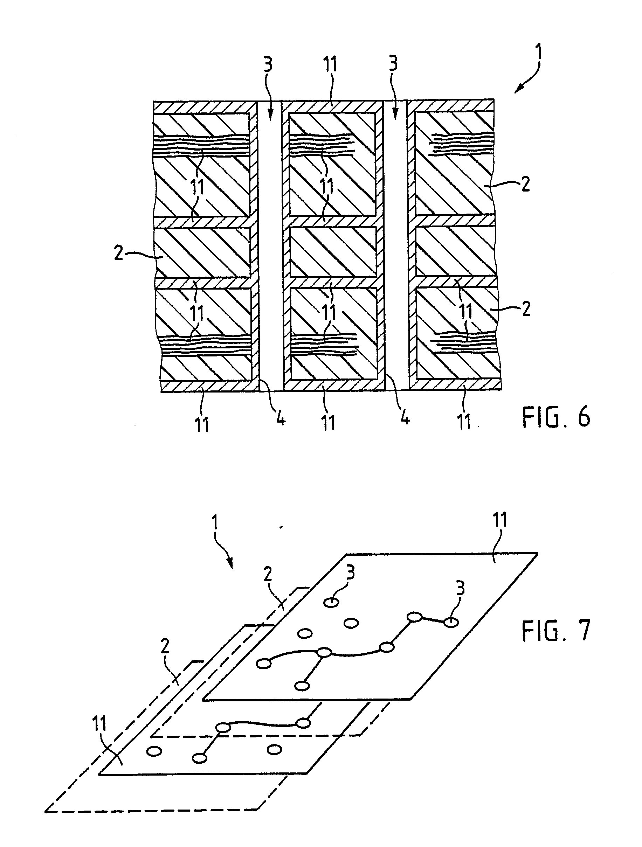

Eine andere Art der Stabilisierung zeigt **Figur 6**, in welchem Aufbau das Kohlfasergewebe (ohne Harz) vor dem Einlaminieren durch einen Galvanikprozess verkupfert, sodass in dieser Ausführungsform keine Kupfer-Kohlefaser-Laminate verwendet werden. Auf diese Weise lassen sich hochstabile und trotzdem sehr dünne Multilayers bei einem Minimum an Aufwand und Kosten herstellen. Die eingebetteten Kohlefasern können gleich, wie weiter oben schon gesagt, als elektrische Leiterbahnen dienen oder auch als Widerstandselemente dort, wo die zusätzlich leitende Beschichtung wieder weggeätzt wird. Grosse Teile eines Layouts können so auf die Kohlefasern übertragen werden, wodurch insbesondere dünne, aber trotzdem schaltungstechnisch hochleistungsfähige Multilayers hergestellt werden können, die mechanisch wesentlich an Stabilität zugenommen haben.

Die mit Kupfer laminierten CFK-Prepregs, mit oder ohne Layoutvorbehandlung, insbesondere aber die galvanisierten Kohlstofffasern, mit oder ohne weggeätzte Kupferbeschichtung, können herstellungstechnisch als Halbzeug angesehen werden, welches zur Herstellung von mehrschichtigen Leiterplatten dient.

**Figur 7** zeigt schematisch, wie bspw. CFK-Schichten 11 aussehen, wenn sie die layoutbezogene Vorbehandlung durchlaufen haben. Nicht eingezeichnet sind die Zwischenschichten, also die geätzten Ebenen mit den Leiterplattenschichten, dagegen sind Ebenen, die aus dem Basismaterial, also aus glasfaserverstärktem Harz bestehen, gestrichelt eingezeichnet. Was in dieser Figur auch nicht dargestellt ist, sind die Elemente der Einlegetechnik gemäss Figur 6, nämlich die stromleitenden Faserbündel, die in einem Multilayer als mechanisch verstärkende und zugleich an der Schaltung teilnehmendes Element vorhanden sein können, und zwar an den Orten innerhalb des Aufbaus, wo sie layoutmässig benötigt werden. Dies sind dann nicht mehr Ebenen oder Schichten. Die asymmetrische, also beliebige Anordnung der Faserbündel begünstigt die stabilisierende Wirkung ohne, wie bspw. im Zusammenhang mit Figur 3 diskutiert wurde, den Nachteil des "Bimetalleffektes" und damit einer Plattenverbiegung aufzuweisen.

Die Verwendung von kohlefaserverstärkten Kompositmaterialien zur Herstellung von Multilayern (Mehrlagen-Leiterplatten) für SMT-Anwendungen (das sind oberflächen montierte Bauelemente) bietet mehrere Vorteile, welche sind: eine gute mechanische Bearbeitungsfähigkeit der Materialien, ein sehr hoher Elastizitätsmodul und sehr kleiner thermischer Ausdehnungskoeffizient der Fasern, ein geringes Gewicht und zu allem dem noch führt der Einsatz dieser Materialien zu wesentlich kostengünstigeren Lösungen als bei der Anwendung von CIC (Kupfer/Invar-Laminate), Molybdän oder Molybdän/Kupfer-Laminate.

## Ansprüche

1. Verfahren zur Herstellung von mehrschichtigen Leiterplatten, dadurch gekennzeichnet, dass mehrere mechanisch verstärkende Mittel in die Leiterplatte einlaminiert werden und dass diese Mittel vor dem einlaminieren durch Vorbehandlung so ausgestaltet werden, dass sie in den auf die Leiterplatte bezogenen Layout integriert sind, sowie funktionell an der elektronischen Schaltung teilnehmen.

2. Verfahren nach Anspruch 1, dadurch gekennzeichnet, dass die einzulaminierenden Lagen ein Prepreg aus Harz und Kohlenstofffasergewebe bestehen und durch Vorbehandlung Ausschnitte und/oder Leiterbahnen in das Prepreg geschnitten werden.

3. Verfahren nach einem der Ansprüche 1 oder 2, dadurch gekennzeichnet, dass mindestens eine vorbehandelt Lage in den mehrschichtigen Aufbau einlaminiert wird.

4. Verfahren nach einem der Ansprüche 1 bis 3, dadurch gekennzeichnet, dass das mechanisch stabilisierende Mittel so vorbehandelt wird, dass es als Bauelement in die elektronische Schaltung einbezogen werden kann.

5. Verfahren nach Anspruch 4, dadurch gekennzeichnet, dass das Bauelement dadurch hergestellt wird, in dem man steckenweise eine elektrisch leitende Beschichtung auf das mechanisch stabilisierende Mittel aufbringt oder Teile einer allfällig vorhandenen elektrisch leitenden Beschichtung entfernt.

6. Mehrschichtige Leiterplatte mit mindestens zwei durch eine elektrisch isolierende Zwischenschicht voneinander beabstandete Leiterebenen, dadurch gekennzeichnet, dass in die Leiterplatte mechanisch verstärkende Mittel einlaminiert sind welche die Leiterplatte versteifen und in vorbestimmten Abschnitten zugleich elektrische Leiterbahnen bilden, die dem elektrischen Layout der Leiterplatte zugeordnet sind.

7. Leiterplatte nach Anspruch 6, dadurch gekennzeichnet, dass das verstärkende Mittel auf elektrisch leitendem Kohlenstoff besteht.

8. Leiterplatte nach Anspruch 7, dadurch gekennzeichnet, dass der elektrisch leitende Kohlenstoff aus Kohlenstofffasern gebildet ist.

9. Leiterplatte nach einem der Ansprüche 6 bis 8, dadurch gekennzeichnet, dass die Kohlenstofffasern als Gewebe in einem Prepreg vorliegen und dieser Prepreg einen auf die Funktion der Leiterplatte bezogenen Layout aufweist.

10. Leiterplatte nach Anspruch 9, gekennzeichnet durch mehrere Ebenen, die Kohlestofffasern enthalten.

11. Leiterplatte nach Anspruch 10, dadurch gekennzeichnet, dass mindestens eine der Ebenen einen auf die elektrische Funktion der Leiterplatte bezogenen Layout aufweist.

12. Leiterplatte nach einem der Ansprüche 6 bis 11, dadurch gekennzeichnet, dass sämtliche Leiterbahnen aus dem verstärkenden Mittel bestehen.

13. Leiterplatte nach Anspruch 12, dadurch gekennzeichnet, dass das verstärkende Mittel Kohlstofffasern sind.

14. Leiterplatte nach einem der Ansprüche 6 bis 13, dadurch gekennzeichnet, dass sie mechanisch verstärkende Mittel aufweisen, die zugleich Elemente der elektronischen Schaltung sind.

FIG. 1

FIG. 2

FIG. 3

FIG. 4

FIG. 5

FIG. 6

FIG. 7

Europäisches
Patentamt

**EUROPÄISCHER RECHERCHENBERICHT**

Nummer der Anmeldung

EP 90 10 1993

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 147 014 (TRW INC.)<br>* Seite 7, Zeilen 9-26; Abbildung 2 *<br>--- | 1-3,6-13 | H 05 K 1/03<br>H 05 K 1/00<br>H 05 K 1/16 |
| A | GB-A-2 080 729 (GENERAL ELECTRIC CO.)<br>* Seite 3, Zeilen 53-87 *<br>--- | 1,6 | |
| A | DE-U-8 813 093 (TELDIX GmbH)<br>* Seite 3, Abbildung 2 *<br>----- | 1-3,6-13 | |

RECHERCHIERTE
SACHGEBIETE (Int. Cl.5)

H 05 K

Der vorliegende Recherchenbericht wurde für alle Patentansprüche erstellt

| Recherchenort | Abschlußdatum der Recherche | Prüfer |
|---|---|---|
| DEN HAAG | 16-07-1990 | SCHUERMANS N.F.G. |